# EUROPEAN PATENT APPLICATION

(11) **EP 3 951 001 A1**
(43) Date of publication of application: **09.02.2022**
(21) Application number: 20020352.9
(22) Date of filing: 04.08.2020
(51) Int. Cl.: C23C 14/00, C23C 14/08, C23C 14/54, C23C 14/02

(54) **A METHOD FOR MAGNETRON SPUTTERING DEPOSITION OF ZINC PEROXIDE FILMS AT CRYOGENIC TEMPERATURE**

(71) Applicant: Latvijas Universitates Cietvielu fizikas instituts, 1063 Riga (LV)
(72) Inventor: Azens, Andris, LV-5120 Plavinas (LV); Zubkins, Martins, LV-1006 Riga (LV); Purans, Juris, LV-1010 Riga (LV)
(74) Representative: Fortuna, Jevgenijs

(57) **Abstract**

The invention relates to a method of magnetron sputtering deposition of Zinc peroxide thin films at cryogenic temperature. The proposed method for deposition of amorphous Zinc peroxide on a substrate by reactive magnetron sputtering, comprising the following steps: (i) positioning a substrate in a vacuum chamber having a magnetron and source for sputtered particles and a process gas shroud means for partially enveloping the magnetron, the substrate having a surface facing the source; (ii) operating the magnetron to sputter particles from the source for coating the substrate surface, including introducing a process gas to the shroud means; (iii) withdrawing and depleting the process gas from the vacuum chamber and creating process pressure below 1×10⁻² mbar, while continuing sputtering particles from the source until the desired thickness of coating on the substrate surface is reached; wherein during the deposition of amorphous Zinc peroxide the substrate is cooled so to keep the substrate temperature below -42° C, preferably, equal to, or below -103° C.

## Description

### Field of the Invention

This invention relates to a method of magnetron sputtering deposition of Zinc peroxide thin films at cryogenic temperature.

### Background Art

Zinc peroxide (ZnO₂) is a wide band gap semiconductor used in photocatalytic, luminescence, ZnO precursor, and water purification applications.-ZnO₂ can be synthesised as a powder, but there are no known methods for deposition of ZnO₂ in the form of a thin film.

Previous study [1] has shown the presence of peroxide ions into the nanocrystalline and amorphous Ir doped/alloyed ZnO films. This suggests that the ZnO₂ phase should be considered in highly disordered zinc oxide structures. ZnO₂ has a pyrite structure *Pa*-3 (No.205) with peroxide (O₂)²⁻ groups [2]. The structure consists of an array of ZnO₆ octahedra, where Zn²⁺ ions are located at the central octahedron. The ZnO₂ decomposes into a hexagonal ZnO phase (2ZnO₂(s) = 2ZnO(s) + O₂ (g)) at about 230°C at ambient pressure [3] and at 100°C in vacuum [4]. It is suggested that the relatively low decomposition temperature is caused by unstable peroxide groups and local charge disbalance in the ZnO₂ structure, where the interatomic distance between two oxygens (1.47 Å) is shorter than the bond length between zinc and oxygen (2.11 Å) [5]. The reported fundamental band gap of ZnO₂ is in the range between 3.3 and 4.6 eV and indirect with the valence band maximum situated at Γ and the conduction band minimum situated between Γ and R [2, 6].

The subject of the invention is ZnO₂ thin films deposited by reactive DC magnetron sputtering on actively cooled substrates (< 0°C). The films have been characterised by X-ray diffraction (XRD), Raman, FTIR, UV-Vis-NIR spectroscopies, and spectroscopic ellipsometry.

### Summary of the Invention

Unless specific thickness values are provided, the term "thin film" in this description refers to a surface coating with the thickness in the range from 470 to 750 nm.

The goal of the invention is to provide a method for deposition of amorphous Zinc peroxide thin film on virtually any rigid or flexible substrate, for instance, on a glass, metal or plastic. The set goal is reached by the proposed method for deposition of amorphous Zinc peroxide on a substrate by reactive magnetron sputtering, comprising the following steps: (i) positioning a substrate in a vacuum chamber having a magnetron and source for sputtered particles and a process gas shroud means for partially enveloping the magnetron, the substrate having a surface facing the source; (ii) operating the magnetron to sputter particles from the source for coating the substrate surface, including introducing a process gas to the shroud means; (iii) withdrawing and depleting the process gas from the vacuum chamber and creating process pressure below 1×10⁻² mbar, while continuing sputtering particles from the source until the desired thickness of coating on the substrate surface is reached; wherein during the deposition of amorphous Zinc peroxide the substrate is actively cooled so to keep the substrate temperature below -42° C, preferably, equal, or below -103° C. The cooling of the substrate can be made by cooling a substrate holder by a liquid or vapour nitrogen flow. The process gas can be a mixture of Ar and O₂. According to the preferred embodiment after the deposition of amorphous Zinc peroxide on a substrate, the substrate is kept in a vacuum until it reaches room temperature without intentional heating and then removed from the vacuum chamber.

As a result of use of the claimed invention about 470-750 nm X-ray amorphous ZnO₂ thin films deposited on actively cooled substrates by reactive magnetron sputtering, were obtained. The films obtained were characterised by X-ray diffraction (XRD), Raman, FTIR, UV-Vis-NIR spectroscopies, and ellipsometry.

According to one embodiment the substrates were cooled by a liquid/vapour nitrogen flow through the copper substrate holder during the deposition.

The X-ray amorphous ZnO₂ films on glass and Ti substrates were obtained at the substrate holder temperature below 0° C. The better properties of the Zinc peroxide films were obtained at the substrate holder temperature equal or below -103° C.

A wurtzite crystalline ZnO structure was observed in the XRD diffractograms when the films were deposited at higher temperatures. The fundamental lattice vibrations of ZnO₂ at 201, 372, and 473 cm⁻¹ as well as O-H stretch and bend absorption bands in the films were detected by FTIR spectroscopy. Raman spectra showed characteristic ZnO₂ peaks at 386 and 858 cm⁻¹ attributed to the peroxide ion O₂²⁻ stretching and libration modes, respectively. In addition, the X-ray amorphous films contain neutral and ionised O₂ and O₂⁻ species. The films are highly transparent in the visible light range and exhibit two optical band gaps of 3.50 eV and 4.65 eV, and a refractive index of 1.68 at 2.25 eV (550 nm).

The proposed method gave an exact band gap values match, confirming the significant blueshift with the amorphization. Two *E_{g}* values were obtained for amorphous ZnO₂ thin film clearly suggesting that this material is composed of two phases. The proposed method i.a. can be used with flexible substrates for technologies where high temperatures are not allowed.

### Brief Description of Drawings

Fig. 1 - Scheme of the reactive magnetron sputtering system equipped with the substrate cooling system.
Fig. 2 - X-ray diffractograms of the thin films deposited on glass as a function of deposition temperature.
Fig. 3 - X-ray diffractograms of the ZnO₂ films deposited on Ti as a function of deposition temperature: +38°C (a), -42°C (b), and -103°C (c).
Fig. 4 - X-ray diffractograms of the ZnO₂ films deposited on Si(111) as a function of deposition temperature: +38°C (a) and -42°C (b).
Fig. 5 - X-ray diffractograms of the ZnO₂ films deposited on CaF₂(111) as a function of deposition temperature: +38°C (a) and -42°C (b).
Fig. 6 - Experimental and calculated X-ray diffractograms of the ZnO₂ powder; inset shows the enlarged part of the diffraction pattern between 50 and 70 °C.
Fig. 7 - Raman spectra of the ZnO₂ films deposited on Ti as a function of deposition temperature: +38°C (a), -42°C (b), and -103°C (c); the figure also contains the Raman spectrum of the ZnO₂ powder (d).
Fig. 8 - Absorption spectra of the ZnO*ₓ* (*x* ≈ 1-2) films deposited on Si(111) in the far IR as a function of deposition temperature: +38°C (a), -42°C (b), and -103°C (c). The figure also contains the absorption spectrum of the ZnO₂ powder (d);
Fig. 9 - Absorption spectra of the ZnO*ₓ* (*x* ≈ 1-2) films deposited on Si(111) in the mid IR as a function of deposition temperature: +38°C (a), -42°C (b), and -103°C (c);
Fig. 10 - Transmittance and reflectance of the ZnO*ₓ* (*x* ≈ 1-2) films on glass substrates in the range of 200 to 1200 nm as a function of deposition temperature: +38°C (a), - 42°C (b), and -103°C (c). The figure also contains the transmittance of soda-lime glass;
Fig. 11 - Transmittance of the ZnO*ₓ* (*x* ≈ 1-2) films on CaF₂(111) in the range of 200 to 1200 nm as a function of deposition temperature. The figure also contains the transmittance of CaF₂. Inset shows a Tauc plot for the crystalline and X-ray amorphous films;
Fig. 12 - Refractive index *n* and extinction coefficient *k* dispersion curves for the ZnO*ₓ* (*x* ≈ 1-2) films deposited atthree different temperatures on glass substrates: +38°C (a), -42°C (b), and -103°C (c).

### Detailed Description of the Invention

The proposed method for deposition of amorphous Zinc peroxide on a substrate by reactive magnetron sputtering, comprising the following steps: (i) positioning a substrate in a vacuum chamber having a magnetron 1 and source for sputtered particles and a process gas shroud means for partially enveloping the magnetron 1, the substrate 2 having a surface facing the source; (ii) operating the magnetron 1 to sputter particles from the source for coating the substrate 2 surface, including introducing a process gas to the shroud means; (iii) withdrawing and depleting the process gas from the vacuum chamber and creating process pressure below 1×10⁻² mbar, while continuing sputtering particles from the source until the desired thickness of coating on the substrate 2 surface is reached; wherein during the deposition of amorphous Zinc peroxide the substrate 2 is actively cooled by a gas supply means 4, so to keep the substrate 2 temperature below -42° C, preferably, equal or below -103° C. The cooling of the substrate 2 can be made by cooling a substrate holder 3 by a liquid or vapour nitrogen flow, supplied via the gas supply means 4. The temperature of the substrate holder 3 can be measured in a temperature measuring point 5 located on, in, or adjacent to the substrate holder 3. The process gas can be a nonreactive (inert) gas only, or a mixture of inert and reactive gas (e.g. Ar and O₂). The deposition can be carried out with single or multielemental targets. According to the preferred embodiment after the deposition of amorphous Zinc peroxide on a substrate 2, the substrate 2 is kept in a vacuum until it reaches room temperature without intentional heating and then removed from the vacuum chamber.

### Examples of implementation of the invention

According to one set of experiments, ZnO₂ 470 - 750 nm thin films were deposited on substrates, by reactive DC magnetron sputtering from Zn target in an Ar+O₂ atmosphere. However, other known process gases also can be used.

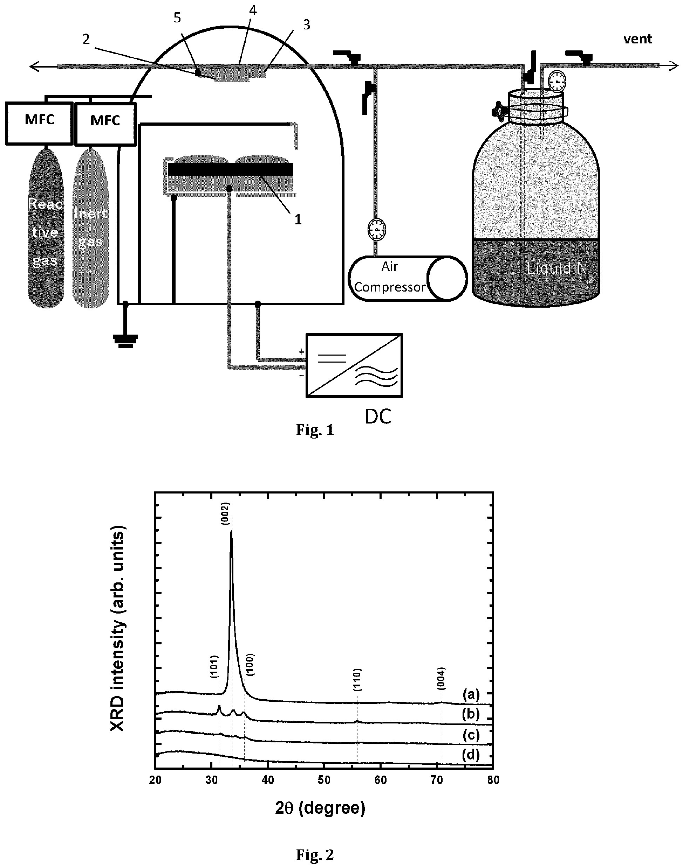

Several types of substrates (e.g. soda-lime glass, Si(111), Ti, and CaF₂(111)) were used to be able to study films by different characterisation techniques. The substrates were cleaned with acetone, detergent, 2-isopropanol in ultrasonic bath for 15 min each, rinsed with distilled water, and then dried under blown N₂ gas. However, for the skilled person it is obvious that the substrates can be cleaned with other suitable substances and not necessarily in the ultrasonic bath. The film deposition was performed using the vacuum coater G500M (Sidrabe Vacuum, Ltd.). However other vacuum coaters having substrate cooling system can be used. The coater was equipped with a substrate cooling system using liquid/vapour nitrogen flow through the grounded copper substrate holder (Fig 1). All types of substrates were stick to the holder using double-sided bonding tape. Before the deposition process, the chamber (≈ 0.1 m³) was pumped down to base pressure below 1.3×10⁻⁵ mbar by a turbo-molecular pump backed with a rotary pump. The films were deposited at different substrate holder temperatures; the experiments in details disclosed in present description relate to temperatures of +38° (without intentional heating or cooling), - 42°, and -103°C. The last two temperatures were obtained adjusting the liquid/vapour nitrogen flow using the valve between the substrate holder and the liquid nitrogen container. When the necessary temperature was reached, the substrate holder was kept at this temperature for 5-15 min to allow all substrate temperatures get even. Then the process gases were introduced into the chamber. The Ar and O₂ gas flow rates were: Ar - from 9.5 to 10.5 sccm, O₂ from 7 to 8 sccm.

The pumping speed was altered by a throttle valve to set the sputtering pressure of 8.0×10⁻³ mbar. At this pressure, process gases do not condensate on the cooled substrates, since their boiling point is well above the liquid nitrogen temperature of 77 K [7].

The target was sputtered in a constant DC mode at a power of 200 W. A planar magnetron with target dimensions 145x92x3 mm was used (however other magnetrons can be used as well). The distance between the target and the substrates was approximately 9 cm. The liquid/vapour nitrogen flow through the holder was increased slightly during the deposition to compensate the additional heating from a plasma discharge and maintain a constant temperature. After the process, the samples were kept in a vacuum until they reached room temperature without intentional heating and then removed from the chamber.

To ensure a good ZnO₂ reference sample, nanocrystalline ZnO₂ powder was directly produced by a hydrothermal process using zinc acetate as a precursor and hydrogen peroxide as an oxidizing agent. 11.4 g of zinc acetate dehydrate (Zn(CH₃COO)₂·2H₂O) were dissolved in 750 ml of deionised water in a round-bottom flask with a dephlegmator and 70 ml of hydrogen peroxide (H₂O₂; sol.30 %). H₂O₂ was added and then the solution was heated up to 100°C to conduct the hydrothermal reaction. Afterwards, the solution was cooled down to room temperature and polycrystalline ZnO₂ was extracted from the liquid and washed with deionised water. The material was finally dried in air for 24 hours.

The structure of the samples was examined by an X-ray diffractometer with Cu Kα radiation, Rigaku MiniFlex 600. Raman scattering spectroscopy measurements were carried out at room temperature using a TriVista CRS Confocal Raman System. A YAG second harmonics laser (532 nm) was used as the excitation source. The incident beam power was about 4 mW. The Fourier transform infrared (FTIR) absorbance spectra were measured by using a VERTEX 80v vacuum FTIR spectrometer. The experiments were performed in the range from 100 to 6000 cm⁻¹, with the interferometer working in vacuum and with a resolution of 4 cm⁻¹.

The film's transmittance and reflectance, in the range of 200 to 1200 nm, were determined by a spectrophotometer, Agilent Cary 7000. The sample was placed at an angle of 6 degrees against the incident beam, and the detector was placed at 180 degrees behind the sample to measure transmittance, and at 12 degrees in front of the sample to measure specular reflectance. Optical properties and film thicknesses were obtained by means of spectroscopic ellipsometer (SE) WOOLLAM RC2 in the spectral range from 210 to 1690 nm or from 5.9 to 0.7 eV. The main ellipsometric angles Ψ and Δ were measured at the incident angles from (55-85)° with the (2-5)° step. Refractive index *n* and extinction coefficient *k* dispersion curves were modelled using two Gaussian and one Cody-Lorentz oscillator (CLO) functions for crystalline samples and single CLO or CLO and Tauc-Lorentz (TLO) for amorphous films. Substrates without films were measured to obtain precise optical properties of the substrates, where later these data were used for the film SE data modelling. SE experimental data model-based regression analyses were performed with the WOOLLAM software Complete EASE^{®}.

Calculations of fundamental vibrations of the ZnO₂ have been performed using the hybrid exchange density functional theory to determine the equilibrium geometries and phonon frequencies. Cubic ZnO₂ was modelled using LCAO methods within the framework of the hybrid density functional approach. To perform hybrid LCAO calculations, the periodic CRYSTAL14 code was used, which employs Gaussian-type functions centred on atomic nuclei as the basis set for expansion of the crystalline orbitals. The full-electron basis sets used in this study for O and Zn were taken from the CRYSTAL basis set library. The Grimme dispersion correction for the energy and gradient has been used in combination with the B3LYP functional.

### X-ray diffraction measurements (XRD)

The evolution of the X-ray diffractograms, recorded over a range for 2θ of 20°-80°, as a function of deposition temperature for the films deposited on glass substrates is shown in Fig. 2. A significant diffraction maximum at around 34° and a low intensity maximum at around 71° are observed for the film deposited at room temperature (+38°C). The maximums correspond to the wurtzite-type ZnO (w-ZnO) lattice planes (002) and (004), respectively.

Fig. 2. X-ray diffractograms of the thin films deposited on glass as a function of deposition temperature: +38°C (a), -42°C (b), and -103°C (d). The films were deposited from a Zn target in a reactive atmosphere (O₂/Ar flow ratio 3/4) at pressure of 8×10⁻³ mbar and at average power of 200 W. The figure also contains the X-ray diffractogram of the post-annealed (100°C, 2.5 h, in a vacuum) film deposited at-103°C (c). The plane indexes correspond to the wurtzite type ZnO structure.

The films lose their crystalline phase orientation with decreasing deposition temperature, and additional maximums of the (100), (101), and (110) planes appear for the film deposited at -42°C. The crystallite size is slightly smaller compared to the sample deposited at room temperature.

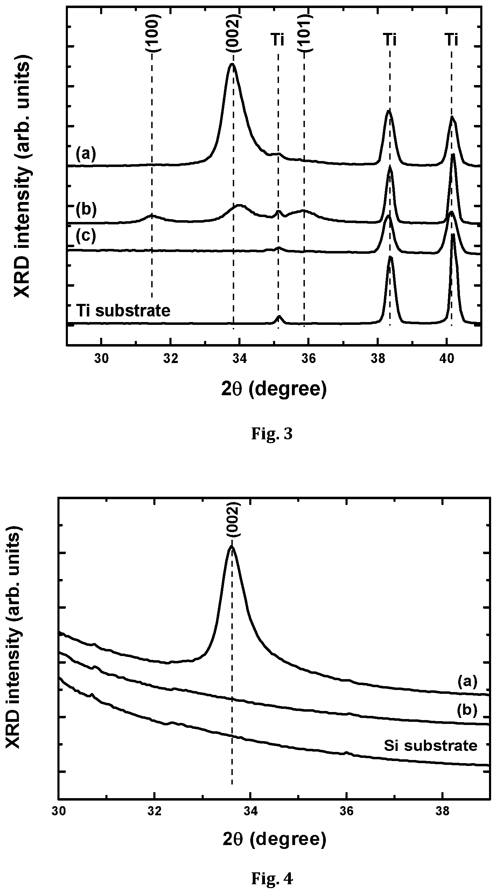

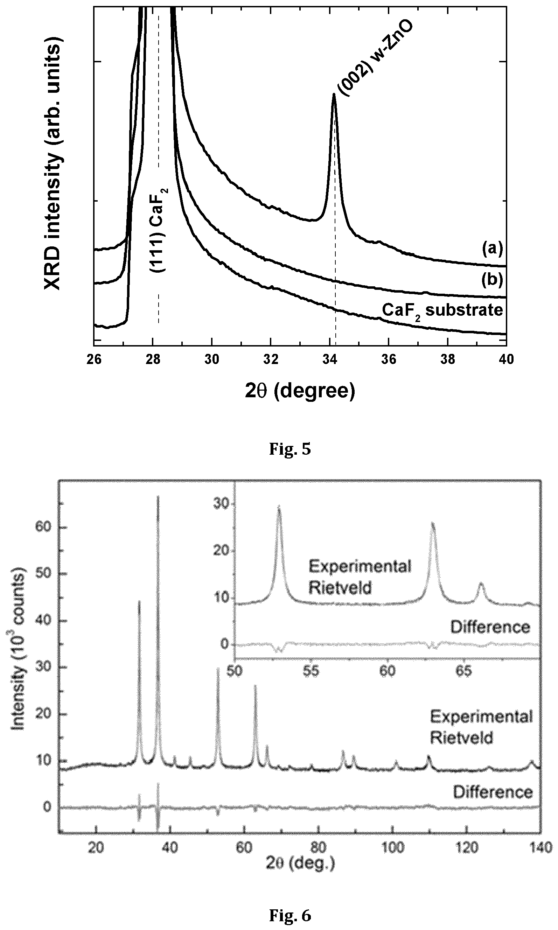

Further decrease of the deposition temperature degrades the crystalline structure and the films become X-ray amorphous at the deposition temperature of - 103°C. The X-ray amorphous film was post-annealed in a vacuum at the temperature of 100°C for 2.5 hours. After annealing, low intensity diffraction maximums (100), (002), and (101) related to w-ZnO structure become apparent. The evolutions of the X-ray diffractograms with the deposition temperature for the films deposited on the Ti substrates are qualitative the same (Fig. 3). However, the films on the Si and CaF₂ substrates become X-ray amorphous already at -42°C (Fig. 4 and Fig. 5).

The X-ray diffractogram of the ZnO₂ powder (Fig. 6) does not show any impurity phases, every visible maximum can be assigned to the ZnO₂ phase with a *Pa*-3 (No.205) space group. Initial lattice parameters and atomic coordinates for the Rietveld refinement were taken from the paper by W. Chen et al [2]. Rietveld refinement was done with the BGMN software using Profex as a graphical user interface. Rietveld refinement gave a very good fit, only some discrepancies between the calculated and experimental X-ray diffractograms can be seen in the most intense maxima of the diffractogram, but the maxima at higher angles shows an excellent fit as can be seen in the inset of Fig. 6 Rietveld refinement allowed an accurate determination of the crystallite size, which was found to be 22 nm.

Fig. 6 Experimental and calculated X-ray diffractograms of the ZnO₂ powder; inset shows the enlarged part of the diffraction pattern between 50 and 70 degrees. *Vibrational analysis (Raman and FTIR spectroscopy)*

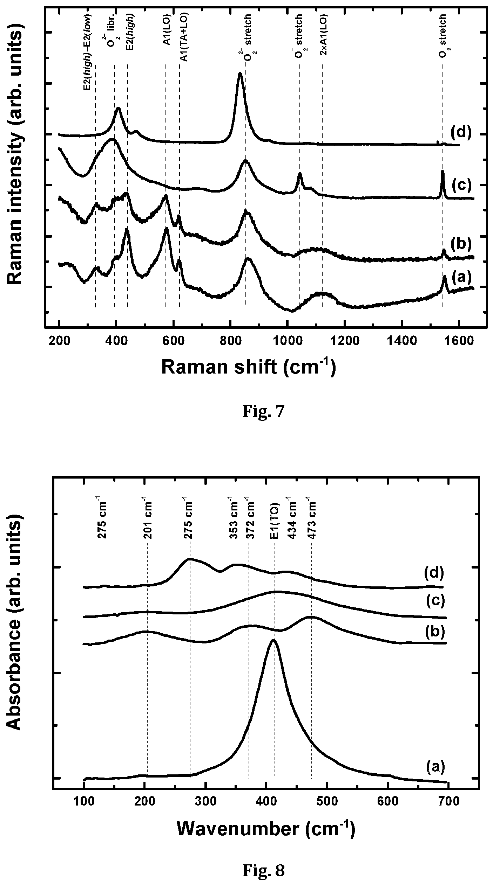

Fig. 7 shows the Raman spectra of the films deposited on Ti substrates as a function of deposition temperature. Bands at 325, 439, 569, 622, 858, 1120, and 1543 cm⁻¹ were observed for the crystalline films deposited at +38 and -42°C. The rest of the bands at 858 and 1543 cm⁻¹ cannot be ascribed to w-ZnO [8]. These bands are caused by the presence of molecular oxygen species, and the bands may be attributed to the stretching modes of O₂²⁻ and O₂, respectively [9]. The molecular oxygen incorporation into the films is due to the relatively high molecular oxygen gas partial pressure used during the deposition.

All the bands that correspond to the w-ZnO phase disappear when the structure becomes X-ray amorphous, while the oxygen bends remain and even new ones appear at 386 and 1042 cm⁻¹. The band at 1042 cm⁻¹ could be assigned to the O₂⁻ stretching, and the band at 386 cm⁻¹ to the O₂²⁻ libration. The oxygen vibration bands at 386 and 858 cm⁻¹, which correspond with the Raman spectra of nanocrystalline ZnO₂ (Fig. 7 and ref. [10]), suggest the formation of a ZnO₂ phase in the X-ray amorphous films deposited at approximately -100°C on Ti.

Fig. 7 Raman spectra of the ZnO₂ films deposited on Ti as a function of deposition temperature: +38°C (a), -42°C (b), and -103°C (c). The figure also contains the Raman spectrum of the ZnO₂ powder (d).

The formation of the ZnO₂ phase in the X-ray amorphous films was also verified by FTIR spectroscopy. In the IR absorption measurements, the films on Si substrates were irradiated perpendicularly to the film's surface with non-polarised light. The absorption spectra of the films in the far IR region as a function of deposition temperature are shown in Fig. 8.

For the room temperature (+38°C) deposited film only the transverse optical mode E₁(TO) of w-ZnO around 411 cm⁻¹ was observed (Fig. 8(a)) because crystallites are c-axis oriented. New absorption bands at 201, 372, and 473 cm⁻¹ (Fig. 8(b)) appear when the film structure becomes X-ray amorphous at the deposition temperature of - 42°C (Fig. 4). The new bands could be ascribed to the ZnO₂ lattice vibrations (see Table 1). It seems that the bands at 372 and 473 cm⁻¹ broaden and overlap each other, and the intensity of the band at 201 cm⁻¹ reduces when the deposition temperature is further decreased (Fig. 8(c)).

Fig. 8 Absorption spectra of the ZnO₂ films deposited on Si(111) in the far IR as a function of deposition temperature: +38°C (a), -42°C (b), and -103°C (c). The figure also contains the absorption spectrum of the ZnO₂ powder (d).

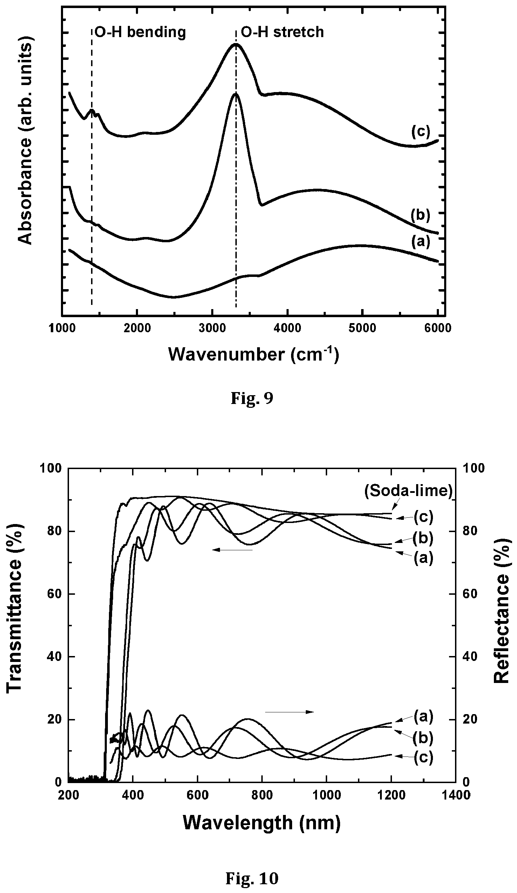

Fig. 9 shows the absorption spectra of the films in the mid IR region as a function of deposition temperature. The spectra of the films deposited on actively cooled substrates (Fig. 9(b,c)) contain the absorption bands at about 3310 and 1400 cm⁻¹, which are attributed to the stretching vibration of the O-H bond and the bending vibration of Zn-O-H, respectively. It is reasonable to assume that films deposited at low growth temperature contain a lot of highly reactive unfilled bonds. Most likely the O-H groups form into the films after a deposition when the air is introduced into the chamber.

Fig. 9. Absorption spectra of the ZnO₂ films deposited on Si(111) in the mid IR as a function of deposition temperature: +38°C (a), -42°C (b), and -103°C (c).

We calculated the lattice parameter *a* of 4.930 Å and the O-O bond distance of 1.525 Å for the fully relaxed ZnO₂ structure. The properties of the calculated and experimentally observed fundamental vibrations are listed in Table 1. The molecular vibrations of anion O₂²⁻ and ionic lattice vibrations of Zn²⁺ and O₂²⁻ were determined. All the molecular stretching and libration vibrations of O₂²⁻ anions are Raman active. Conversely, the lattice vibrations are Raman inactive and only a part of those are IR active.

The calculated vibration frequencies are in good agreement with the observed Raman and IR frequencies of the produced ZnO₂ powder, but are quite shifted in the films. This could be explained by the amorphous structure and the presence of the O-H groups. Our calculations predict two Raman active stretching vibrations at 907 and 908 cm⁻¹ and three Raman active libration vibrations at 407, 413, and 471 cm⁻¹. The experimental Raman spectra of the films showed only one stretching band at 858 cm⁻¹ and one libration band at 386 cm⁻¹. The theoretically predicted IR bands at 143 and 271 cm⁻¹ were not observed.

**Table 1**

| Calculated and experimentally observed fundamental vibrations of ZnO₂ | | | | | |
|---|---|---|---|---|---|
| Calculated | Frequency (cm¹) Experimental (X-ray amorphous thin film) | Experimental (powder) | Symmetry | Activity | Types |
| 141 | - | - | Eᵤ | - | Lattice |
| 143 | - | 135 | Fᵤ | IR | Lattice |
| 152 | - | - | Aᵤ | - | Lattice |
| 203 | 201 | 200 | Fᵤ | IR | Lattice |
| 271 | - | 275 | Fᵤ | IR | Lattice |
| 305 | - | - | Aᵤ | - | Lattice |
| 347 | 372 | 347 | Fᵤ | IR | Lattice |
| 376 | - | - | Eᵤ | - | Lattice |
| 407 | 386 | 410 | F_{g} | Raman | O₂²⁻ libration |
| 413 | - | - | E_{g} | Raman | O₂²⁻ libration |
| 432 | 473 | 434 | Fᵤ | IR | Lattice |
| 475 | - | 471 | F_{g} | Raman | O₂²⁻ libration |
| 907 | 858 | 838 | A_{g} | Raman | O₂²⁻ stretching |
| 908 | - | - | F_{g} | Raman | O₂²⁻ stretching |

### Optical properties

### UV-Vis-IR transmittance and reflectance spectra

Fig. 10 shows the specular transmittance and reflectance of the films deposited on soda-lime glass measured in the range from 200 to 1200 nm. All the films exhibit high transmittance in the visible light range, limited mainly by the reflectance of approximately 15% and 9% (average values in the visible range) for the crystalline and X-ray amorphous films, respectively. Thus, the average transmittance in the visible range of the amorphous film (≈87%) is slightly higher compared to the crystalline samples (≈80%). All the spectra exhibit an interference fringe, which indicates that both the surface and the interface with a glass substrate are optically smooth. The oscillation amplitude of transmittance and reflectance curves decreases together with the structure amorphization. It is due to the lower refractive index for the X-ray amorphous film: refractive index of these films becomes comparable with the refractive index's values of the glass substrate.

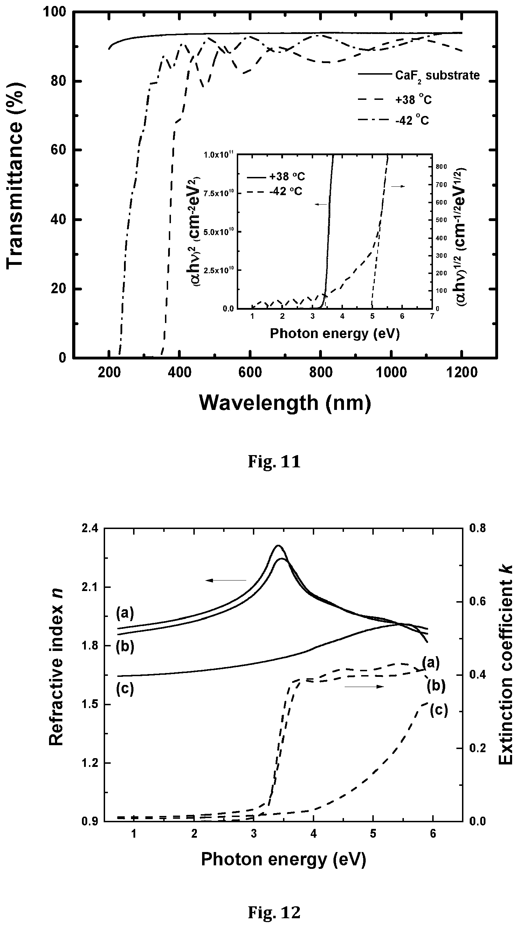

The sharp fall in transmittance below 400 nm is due to the onset of fundamental absorption of ZnO₂. The change of the film structure with the deposition temperature can be indirectly evaluated by observing a fundamental absorption edge shift. The significant blueshift of the edge is observed when the film becomes X-ray amorphous. As soda-lime glass strongly absorbs in the UV part, the films were also deposited on the CaF₂ substrates to be able to determine an optical band gap by applying the Tauc model (Fig. 11). The optical band gap of ∼3.43 eV for the crystalline sample is in good agreement with the bulk value of ZnO, but for the amorphous one the optical band gap is primarily determined to be ∼4.97 eV. At the same time, another band edge absorption feature with an associated Tauc gap of ∼3.22 eV is observed. This point will be discussed in more detail together with the ellipsometry data analysis. It is known from other reports that the band gap of ZnO₂ is in the range from 3.3 to 4.6 eV [2, 6].

Fig. 10. Transmittance and reflectance of the ZnO₂ films on glass substrates in the range of 200 to 1200 nm as a function of deposition temperature: +38°C (a), -42°C (b), and -103°C (c). The figure also contains the transmittance of soda-lime glass.

Fig. 11. Transmittance of the ZnO₂ films on CaF₂(111) in the range of 200 to 1200 nm as a function of deposition temperature. The figure also contains the transmittance of CaF₂. Inset shows a Tauc plot for the crystalline and X-ray amorphous films.

### Spectroscopic ellipsometry

The MSE (mean square error) of the model compared to experimental SE data was reduced from 9 to 7 for the films deposited at -103°C by introducing in the model an interface layer between the substrate and the film: the thickness of the interface layer estimated by SE is approximately 15 nm. For other films the interface layer was not giving any improvement in the model. Some of parameters obtained from SE are summarized in the Table 2.

**Table 2**

| The roughness, interphase, film thickness, optical band gap energy E*_{g}*, Urbach energy E*ᵤ* and refractive index *n* at 1.960 eV (632.8 nm) obtained for the ZnO₂ films deposited at different temperatures using SE data. | | | | | | |
|---|---|---|---|---|---|---|
| Deposition temperature (°C) | Roughness (nm) | Interphase (nm) | Thickness (nm) | E_{g} (eV) | Eᵤ (meV) | n at 1.96 eV (632.6 nm) |
| +38 | 3.72 ± 0.01 | - | 492.19 ± 0.03 | 3.117 ± 0.002 | 77 ± 2 | 1.951 ± 0.002 |
| -42 | 5.73 ± 0.03 | - | 473.11 ± 0.11 | 3.191 ± 0.022 | 951 ± 7 | 1.923 ± 0.004 |
| -103 | 3.26 ± 0.05 | 15.5 ± 0.5 | 655.40 ± 0.32 | 3.50 ± 0.15 | 1100 ± 50 | 1.666 ± 0.006 |
| | | | | 4.65 ± 0.40 | | |

Refractive index *n* and extinction coefficient k dispersion curves for the films deposited atthree different temperatures on glass substrates are given in Fig. 12. There is a significant change in the refractive index and optical bang gap when the deposition temperature decreases from -42 to -103°C, which is related with the phase change from crystalline ZnO*ₓ* to X-ray amorphous ZnO_{2-*x*}. The refractive index at 1.96 eV decreases from 1.92 to 1.67 (Table 2). The refractive index values from 1.66 to 1.71 in the visible range of the X-ray amorphous film is in good agreement with ZnO₂ data from the literature [4].

Fig. 12. Refractive index *n* and extinction coefficient k dispersion curves for the ZnO₂ films deposited at three different temperatures on glass substrates: +38°C (a), - 42°C (b), and -103°C (c).

The optical band gap energy *E_{g}* was obtained directly from the CLO and TLO as *E_{g}* is one of the oscillator parameters. The CLO includes Urbach absorption term [*Eᵤ* - Urbach energy) to model absorption below *E_{g}.* The choice of CLO was because all samples represented significant Urbach type absorption below *E_{g}* due to the presence of a free exciton just below the gap. The optical dispersion curves for the sample deposited at -103°C was generated using two oscillator model (CLO and TLO) according to the transmission spectra (Fig. 10(c)), where slight absorption "shoulder" around 350 nm is observed. Other samples were fitted using single CLO and two Gaussian oscillators. The *E_{g}* values for the three films obtained from CLO and TLO are summarized in the Table 2.

The two band gap values for the films deposited at -103°C are representing the absorption edges at 3.50 eV and 4.65 eV. The obtained bang gap at 4.65 ± 0.40 eV is in good agreement with the data obtained from absorption spectra (Fig. 11) fitted using Tauc relation. Similar two *E_{g}* values can be obtained using Tauc relation to fit extinction coefficient curve simulated with CLO+TLO. More detailed investigation should be done to clarify this two-band gap nature of amorphous ZnO₂ films.

The X-ray amorphous structure of ZnO₂ can be obtained by reducing the deposition temperature, but the exact temperature at which the amorphization takes place depends on the substrate material. The presence of the ZnO₂ phase was observed by Raman and FTIR spectroscopies. The observed vibration bands are wide and shifted compared to the ZnO₂ powder spectra, which is explained by the highly disorder structure and the additional defects as O-H groups and various oxygen species.

The X-ray amorphous ZnO₂ films have considerably lower refractive index and higher optical bang gap compared to crystalline ZnO.

### References

[1] M. Zubkins, R. Kalendarev, J. Gabrusenoks, A. Plaude, A. Zitolo, A. Anspoks, K. Pudzs, K. Vilnis, A. Azens, J. Purans, Changes in structure and conduction type upon addition of Ir to ZnO thin films, Thin Solid Films 636 (2017) 694-701, https://doi.org/10.1016/j.tsf.2017.05.049.
[2] W. Chen, Y. H. Lu, M. Wang, L. Kroner, H. Paul, H. J. Fecht, J. Bednarcik, K. Stahl, Z. L. Zhang, U. Wiedwald, U. Kaiser, P. Ziemann, T. Kikegawa, C. D. Wu, J. Z. Jiang, Synthesis, thermal stability and properties of ZnO2 nanoparticles, The journal of physical chemistry C 113(4) (2009) 1320-1324, https://doi.org/10.1021/jp808714v.
[3] N. Uekawa, N. Mochizuki, J. Kajiwara, F. Mori, Y. J. Wu, K. Kakegawa, Nonstoichiometric properties of zinc oxide nanoparticles prepared by decomposition of zinc peroxide, Physical Chemistry Chemical Physics 5(5) (2003) 929-934, https://doi.org/10.1039/B210990E.
[4] S. Lindroos, M. Leskelä, Growth of zinc peroxide (ZnO2) and zinc oxide (ZnO) thin films by the successive ionic layer adsorption and reaction-SILAR-technique, International Journal of Inorganic Materials 2(2-3) (2000) 197-201, https://doi.org/10.1016/S1466-6049(00)00017-9.
[5] A. Escobedo-Morales, R. Esparza, A. García-Ruiz, A. Aguilar, E. Rubio-Rosas, R. Pérez, Structural and vibrational properties of hydrothermally grown ZnO2 nanoparticles, Journal of Crystal Growth 316(1) (2011) 37-41, https://doi.org/10.1016/j,jcrysgro.2010.12.057.
[6] D. Yang, M. A. Gondal, Z. H. Yamani, U. Baig, X. Qiao, G. Liu, Q. Xu, D. Xiang, M. Junkui, K. Shen, 532 nm nanosecond pulse laser triggered synthesis of ZnO2 nanoparticles via a fast ablation technique in liquid and their photocatalytic performance, Materials Science in Semiconductor Processing 57 (2017) 124-131, https://doi.org/10.1016/j.mssp.2016.09.043.
[7] J. Bruncko, M. Netrvalova, A. Vincze, P. Sutta, M. Michalka, F. Uherek, Pulsed laser deposition of thin films on actively cooled substrates, Vacuum 98 (2013) 56-62, https://doi.org/10.1016/j.vacuum.2013.01.024.
[8] R. Cuscó, E. Alarcón-Lladó, J. Ibanez, L. Artús, J. Jiménez, B. Wang, M. J. Callahan, Temperature dependence of Raman scattering in ZnO, Physical Review B 75(16) (2007) 165202, https://doi.org/10.1103/PhysRevB.75.165202.
[9] L. Vaska, Dioxygen-metal complexes: toward a unified view, Accounts of Chemical Research 9(5) (1976) 175-183, https://doi.org/10.1021/ar50101a002.
[10] L. Y. Yang, G. P. Feng, T. X. Wang, Green synthesis of ZnO2 nanoparticles from hydrozincite and hydrogen peroxide at room temperature, Materials Letters 64(14) (2010) 1647-1649, https://doi.org/10.1016/j.matlet.2010.04.022.

## Claims

1. A method for deposition of amorphous Zinc peroxide on a substrate by reactive magnetron sputtering, comprising the following steps:
(i) positioning a substrate in a vacuum chamber having a magnetron and source for sputtered particles and a process gas shroud means for partially enveloping the magnetron, the substrate having a surface facing the source;
(ii) operating the magnetron to sputter particles from the source for coating the substrate surface, including introducing a process gas to the shroud means;
(iii) withdrawing and depleting the process gas from the vacuum chamber and creating process pressure below 1 ×10⁻² mbar, while continuing sputtering particles from the source until the desired thickness of coating on the substrate surface is reached; wherein during the deposition of amorphous Zinc peroxide the substrate is cooled so to keep the substrate temperature below -42° C, preferably, equal to, or below -103° C.

2. The method according to claim 1, wherein cooling of the substrate is made by cooling a substrate holder by a liquid or vapour nitrogen flow.

3. The method according to any proceeding claims, wherein the process gas is a mixture of Ar and O₂.

4. The method according to claim 3, wherein the process gas is introduced to the shroud means with the following gas flow rates: Ar - from 9.5 to 10.5 sccm, O₂ from 7 to 8 sccm.

5. The method according to any proceeding claims, wherein before positioning the substrate in a vacuum chamber at the step (i) the substrate is cleaned with acetone, detergent and 2-isopropanol in ultrasonic bathes, rinsed with distilled water, and then dried under blown N₂ gas.

6. The method according to any proceeding claims, wherein after the deposition of amorphous Zinc peroxide on a substrate the substrate is kept in a vacuum until it reaches room temperature without intentional heating.
